# EUROPÄISCHE PATENTSCHRIFT

(11) **EP 0 878 026 B1**
(45) Veröffentlichungstag und Bekanntmachung des Hinweises auf die Patenterteilung: **24.07.2002**
(21) Anmeldenummer: 97907037.2
(22) Anmeldetag: 31.01.1997
(51) Int. Cl.: H01L 25/075, H01L 33/00

(54) **LEUCHTDIODENMATRIX**
LED MATRIX
MATRICE A DIODES ELECTROLUMINESCENTES

(30) Priorität: 31.01.1996 DE 19603444
(43) Veröffentlichungstag der Anmeldung: 18.11.1998
(73) Patentinhaber: Osram Opto Semiconductors GmbH & Co. OHG, 93049 Regensburg (DE)
(72) Erfinder: GRAMANN, Wolfgang, D-93053 Regensburg (DE); SPÄTH, Werner, D-83607 Holzkirchen (DE); WAITL, Günther, D-93049 Regensburg (DE); BRUNNER, Herbert, D-93047 Regensburg (DE)
(74) Vertreter: Epping, Wilhelm, Dipl.-Ing.
(86) Internationale Anmeldenummer: DE9700190
(87) Internationale Veröffentlichungsnummer: WO9728565

(56) Entgegenhaltungen:
- JP-A- 8 018 105
- US-A- 5 250 820
- PATENT ABSTRACTS OF JAPAN vol. 011, no. 031 (E-475), 29.Januar 1987 & JP 61 198690 A (OSHINO DENKI SEISAKUSHO:KK), 3.September 1986,
- PATENT ABSTRACTS OF JAPAN vol. 006, no. 119 (E-116), 3.Juli 1982 & JP 57 045983 A (TOSHIBA CORP), 16.März 1982,
- PATENT ABSTRACTS OF JAPAN vol. 006, no. 032 (E-096), 26.Februar 1982 & JP 56 152281 A (TOSHIBA CORP), 25.November 1981,

## Beschreibung

Die Erfindung bezieht sich auf eine LED-Vorrichtung mit mindestens einem LED-Chip, bei dem auf einer Lichtaustrittsfläche eines lichtemittierunden Körpers eine Vorderseitenkontaktmetallisierung und auf einer der Lichtaustrittsfläche gegenüberliegenden Seite des lichtemittierunden Körpers eine Rückseitenkontaktmetallisierung angeordnet ist.

Derartige LED-Vorrichtungen sind beispielsweise aus Cuno, H. H.; Heider, A.: Das LED-Display, ein vielseitiges Anzeigenelement; elektronik industrie 1-1991 bekannt. Hierin ist ein LED-Segment beschrieben, bei der ein eine Vorderseitenkontaktmetallisierung und eine Rückseitenkontaktmetallisierung aufweisender LED-Chip mit seiner Rückseite auf einem ersten elektrischen Anschlußteil befestigt ist. Die Vorderseitenkontaktmetallisierung ist mit einem Kontaktierdraht versehen, der die Vorderseitenkontaktmetallisierung mit einem zweiten elektrischen Anschlußteil verbindet.

Weiterhin sind LED-Vorrichtungen der eingangs genannten Art bekannt, bei denen eine Mehrzahl von LED-Chips mit ihren Rückseitenkontaktmetallisierungen entsprechend einem vorgegebenen Raster auf Leiterbahnen einer Platine befestigt sind, die die Rückseitenkontaktmetallisierungen zeilen- oder spaltenweise untereinander elektrisch leitend verbinden. Die Vorderseitenkontaktmetallisierungen sind als Bondpad ausgebildet und mittels Bonddrähten spalten- bzw. zeilenweise untereinander elektrisch leitend verbunden. Zum Schutz gegen mechanische Beschädigung ist über den LED-Chips meist eine durchsichtige Kunststoffplatte angeordnet, die zusammen mit der Platine in ein Kunscstoffgehäuse eingebaut ist.

Bei sogenannten intelligenten LED-Anzeigevorrichtungen, die z. B. unter der Bezeichnung "Intelligent Display®" im Handel und derzeit nach dem oben beschriebenen Prinzip aufgebaut sind, sind die Zeilen und Spalten an eine elektronische Ansteuerschaltung angeschlossen, die die LED-Chips derart mit Strom bzw. Stromimpulsen versorgt (Pulscode-Modulation), daß sie nach einem vorgegebenen Muster aufleuchten. Die Ansteuerschaltung kann beispielsweise auf der Rücksteite der Platine oder auch extern angebracht sein. Solche intelligenten LED-Anzeigevorrichtungen werden z. B. in Mobiltelefonen zur Telefonnummern- und Betriebszustandsanzeige eingesetzt, da sie selbstleuchtend sind und daher keine zusätzliche Beleuchtung, wie sie beispielsweise bei LCD-Displays notwendig ist, benötigen.

Die oben beschriebenen bekannten LED-Vorrichtungen werden mittels herkömmlicher Die- und Wirebondtechniken hergestellt. Die Vorderseitenkontaktmetallisierungen sind als Bondpads ausgebildet und decken damit einen Teil der Lichtaustrittsflächen der LED-Chips ab. Damit das Verhältnis von Lichtaustrittsfläche zu Bondpadfläche und somit die Lichtausbeute aus einem LED-Chip nicht zu gering wird, darf bei den heute zur Verfügung stehenden herkömmlichen Bondtechniken der Querschnitt des LED-Chips in Draufsicht 0,2 × 0,2 mm² nicht unterschreiten.

Die Kosten, das Gewicht und die Abmessungen der o. g. LED-Vorrichtungen sind im wesentlichen von der Größe der LED-Chips abhängig. Ebenso ist die Leuchtpunktdichte (Anzahl der Leuchtdioden pro Flächeneinheit) und damit auch die Bildqualität der oben beschriebenen LED-Displays im wesentlichen von der Größe der einzelnen LED-Chips und deren Abstand voneinander abhängig. Eine Verringerung der Baugröße der LED-Chips ist daher besonders erstrebenswert.

Eine Reduktion der Chipfläche auf beispielsweise 0,15 x 0,15 mm² würde eine deutliche Reduzierung der Bondpadfläche erfordern, um nicht gleichzeitig die Lichtausbeute aus dem LED-Chip drastisch zu verschlechtern. Dies würde aber bei einem Einsatz herkömmlicher Bondtechniken erhebliche technische Probleme mit sich bringen.

Derartige LED-Vorrichtungen sind auch in JP-A-61198690, JP-A-8018105 und US-A-5250820 offenbart.

Der Erfindung liegt daher die Aufgabe zugrunde, eine LED-Vorrichtung zu entwickeln, bei der die Größe der LED-Chips verringert ist. Gleichzeitig soll diese LED-Vorrichtung eine geringe Baugröße und ein geringes Gewicht aufweisen, kostengünstig herstellbar sein und hohe mechanische und thermische Stabilität besitzen.

Diese Aufgabe wird durch eine LED-Vorrichtung mit den Merkmalen des Patentanspruches 1 gelöst. Vorteilhafte Weiterbildungen der erfindungsgemäßen LED-Vorrichtung sind Gegenstand von Unteransprüchen.

Es ist vorgesehen, daß der LED-Chip zwischen einem ersten und einem zweiten Leiterbahnträger angeordnet ist, daß der erste Leiterbahnträger lichtdurchlässig ist und mindestens einen ersten elektrischen Leiter aufweist, der die Vorderseitenkontaktmetallisierung kontaktiert, und daß der zweite Leiterbahnträger mindestens einen zweiten elektrischen Leiter aufweist, der die Rückseitenkontaktmetallisieruung kontaktiert.

Die erfindungsgemäße Anordnung kann sowohl bei Vorrichtungen mit einer Mehrzahl von LED-Chips als auch bei Vorrichtungen mit einem einzigen LED-Chip verwendet werden.

Da es bei der erfindungsgemäßen LED-Vorrichtung nicht erforderlich ist, die Vorderseitenkontaktmetallisierung des LED-Chips mit einem Bonddraht zu versehen, kann vorteilhafterweise erstens die Vorderseitenkontaktmetallisierung bedeutend kleiner ausgebildet sein als bisher und ist zweitens nicht mehr die Positionierungstoleranz eines zur Herstellung eingesetzten Drahtbonders der entscheidende Parameter für die Größe des LED-Chips, sondern die Genauigkeiten, mit der der LED-Chip und der erste elektrische Leiter auf dem ersten Leiterbahnträger positioniert werden können. Darüberhinaus kann auch der Querschnitt des ersten elektrischen Leiters gegenüber dem Drahtdurchmesser herkömmlicher Bonddrähte deutlich verringert werden. Aus diesen Gründen ist es mit der erfindungsgemäßen LED-Vorrichtung möglich, die Abmessungen des LED-Chips zu verringern und damit die Leuchtpunktdichte von LED-Displays zu erhöhen. Außerdem kann vorteilhafterweise bei der erfindungsgemäßen LED-Vorrichtung die Lichtausbeute aus den LED-Chips gegenüber der herkömmlich verwendeter LED-Chips verbessert sein.

Die erfindungsgemäße LED-Vorrichtung hat den Vorteil, daß LED-Chips mit den Abmessungen von z. B. 0,15 × 0,15 mm², 0,12 × 0,12 mm² oder noch kleiner verwendet werden können. Dadurch können vorteilhafterweise die Materialkosten für LED-Vorrichtungen und deren Gewicht deutlich gesenkt werden. Zudem kann vorteilhafterweise der Stromverbauch der erfindungsgemäßen LED-Vorrichtung gegenüber dem herkömmlicher LED-Vorrichtungen reduziert werden, da die Lichtausbeute von LED-Chips meist überproportional mit der Stromdichte ansteigt.

Bei einer bevorzugten Weiterbildung der Erfindung kann vorgesehen sein, daß die Vorderseitenkontaktmetallisierung eines jeden LED-Chips mehrere in einem Abstand voneinander angeordnete Kontaktmetallisierungsstreifen aufweist. Damit ist es möglich, bei einem LED-Chip die von der Vorderseitenkontaktmetallisierung abgedeckte Chipoberfläche (Lichtaustrittsfläche) weiter zu verringern und damit die Lichtausbeute aus dem LED-Chip zu erhöhen.

Von Vorteil ist weiterhin, wenn sich die Kontaktmetallisierungsstreifen und der dem LED-Chip zugeordnete erste elektrische Leiter kreuzen. Damit lassen sich die zulässigen Positionierungstoleranzen für den LED-Chip, den ersten elektrischen Leiter und den ersten Leiterbahnträger vorteilhafterweise deutlich erhöhen.

Bei der ersten Ausgestaltung der Erfindung ist vorgesehen, daß jeder erste elektrische Leiter eine Mehrzahl von in einem Abstand zueinander auf dem ersten Leiterbahnträger aufgebrachte Leiterbahnmetallisierungsstreifen aufweist. Dadurch ist vorteilhafterweise der von Metallisierungen abgedeckte Bereich auf dem ersten Leiterbahnträger nochmals reduziert.

Um die Kontaktierungssicherheit zwischen den Leiterbahnmetallisierungsstreifen und der Vorderseitenkontaktmetallisierung zu verbessern, weisen bei einer bevorzugten Weiterbildung der Erfindung die Leiterbahnmetallisierungsstreifen im Kontaktbereich zur Vorderseitenkontaktmetallisierung Verbreiterungen, beispielsweise in Form von Querstegen auf.

Um mögliche Reflexionsverluste innerhalb der LED-Vorrichtung zu verhindern, können freie Zwischenräume zwischen den Lichtaustrittsflächen des LED-Chips und dem ersten Leiterbahnträger oder auch der gesamte freie Zwischenraum zwischen dem ersten und dem zweiten Leiterbahnträger vorteilhafterweise mit einem optischen Koppelmedium gefüllt sein, das interne Reflexionen in der LED-Vorrichtung vermindert.

Bei einer besonders bevorzugten Weiterbildung der Erfindung ist zwischen dem ersten und dem zweiten Leiterbahnträger eine Mehrzahl von LED-Chips angeordnet. Auf dem ersten Leiterbahnträger ist eine Mehrzahl von ersten elektrischen Leitern vorgesehen, von denen jeder die Vorderseitenkontaktmetallisierung von mindestens einem LED-Chip kontaktiert. Ebenso ist auf dem zweiten Leiterbahnträger eine Mehrzahl von zweiten elektrischen Leitern vorgesehen, von denen jeder die Rückseitenkontaktmetallisierung von mindestens einem LED-Chip kontaktiert.

Eine vorteilhafte Weiterbildung der letztgenannten Ausführungsform der erfindungsgemäßen LED-Vorrichtung besteht darin, die LED-Chips auf einem zweiten Leiterbahnträger, der aus einer Mehrzahl von separaten mit zweiten elektrischen Leitern, z. B. Metallisierungen, versehenen, im Querschnitt beispielsweise rechteckigen Trägerbalken besteht, anzuordnen. Jeder dieser Trägerbalken erstreckt sich über eine Gruppe von LED-Chips. Durch die Verwendung dieser voneinander getrennten Trägerbalken kann bei Einsatz von Materialien mit unterschiedlichen thermischen Ausdehnungskoeffizienten für den ersten und den zweiten Leiterbahnträger eine Verringerung der mechanischen Spannungen innerhalb der Anzeigevorrichtung erzielt werden. Idealerweise ist jeder zweite elektrische Leiter auf einem gesonderten Trägerbalken aufgebracht oder ausgebildet. Unterschiedliche thermische Ausdehnungskoeffizienten von in der LED-Vorrichtung eingesetzten Materialien können nämlich bekannterweise bei Temperaturschwankungen mechanische Spannungen in der LED-Vorrichtung hervorrufen, die beispielsweise zu Schädigungen der LED-Chips führen können.

Anstelle der Trägerbalken kann als zweiter Leiterbahnträger eine einzige einteilige elektrisch isolierende Platte verwendet sein, auf der die zweiten elektrischen Leiter aufgebracht oder ausgebildet sind.

Um die oben genannten mechanischen Spannungen so weit als möglich zu unterbinden, sind bei einer weiterhin bevorzugten Ausführungsform der erfindungsgemäßen Vorrichtung der erste und der zweite Leiterbahnträger aus Materialien hergestellt, die ähnliche thermische Ausdehnungskoeffizienten aufweisen.

Eine weitere vorteilhafte Ausgestaltung der Erfindung besteht darin, daß die zweiten elektrischen Leiter oder Verbindungsmittel zwischen den Rückseitenkontaktmetallisierungen und den zweiten elektrischen Leitern plastisch oder elastich verformbar ausgebildet sind. Toleranzen in den Chipabmessungen und/oder Unebenheiten des ersten und/oder zweiten Leiterbahnträgers werden demzufolge ausgeglichen, indem sich die zweiten elektrischen Leiter oder das Verbindungsmittel zwischen den Rückseitenkontaktmetallisierungen und den zweiten elektrischen Leitern entsprechend zusammendrücken läßt.

Zur Erfüllung des gleichen Zwecks ist es ebenso denkbar, einen der beiden oder beide Leiterbahnträger vorteilhafterweise als elastische Folie (z. B. aus Kunststoff) auszubilden, die mit Leiterbahnen versehen ist.

Der Vollständigkeit halber sei an dieser Stelle noch erwähnt, dass mit Vorderseite und Rückseite eines LED-Chips in der Regel die Betrachterseite bzw. die Montageseite des Chips gemeint ist.

Weitere Vorteile, Merkmale und Zweckmäßigkeiten der Erfindung ergeben sich aus der folgenden Beschreibung zweier Ausführungsbeispiele in Verbindung mit den Figuren 2 bis 7. Es zeigen:
- Figur 1: eine schematische Darstellung einer Seitenansicht eines nicht zur Erfindung gehörenden Ausführungsbeispiels;
- Figur 2a: eine schematische Darstellung einer Draufsicht auf das erste Ausführungsbeispiel der Erfindung;
- Figur 2b: eine schematische Darstellung eines Schnittes durch das erste Ausführungsbeispiel entlang der in Figur 2a eingezeichneten Linie A-A;
- Figur 2c: eine schematische Darstellung eines Schnittes durch das erste Ausführungsbeispiel entlang der in Figur 2a eingezeichneten Linie B-B;
- Figur 3a: eine schematische Darstellung eines im ersten Ausführungsbeispiel verwendeten LED-Chips;
- Figur 3b: eine schematische Darstellung der Draufsicht auf einen im ersten Ausführungsbeispiel verwendeten LED-Chips;
- Figur 4: eine schematische Schnittansicht eines zweiten Ausführungsbeispieles der erfindungsgemäßen LED-Vorrichtung;
- Figur 5: eine schematische Schnittansicht einer erfindungsgemäßen LED-Vorrichtung, bei der zwischen den LED-Chips und dem ersten Leiterbahnträger ein optisches Koppelmedium angeordnet ist;
- Figur 6: eine schematische Schnittansicht einer erfindungsgemäßen LED-Vorrichtung, bei der Zwischenraum zwischen dem ersten und dem zweiten Leiterbahnträger mit einem optischen Koppelmedium gefüllt ist.
- Figur 7: eine schematische Schnittansicht einer erfindungsgemäßen LED-Vorrichtung, bei der der zweite Leiterbahnträger elektrisch leitende Durchführungen aufweist.

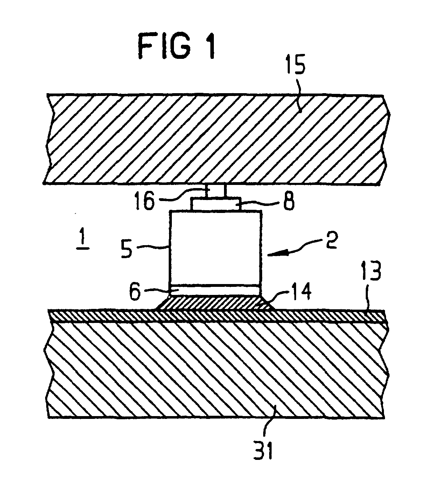

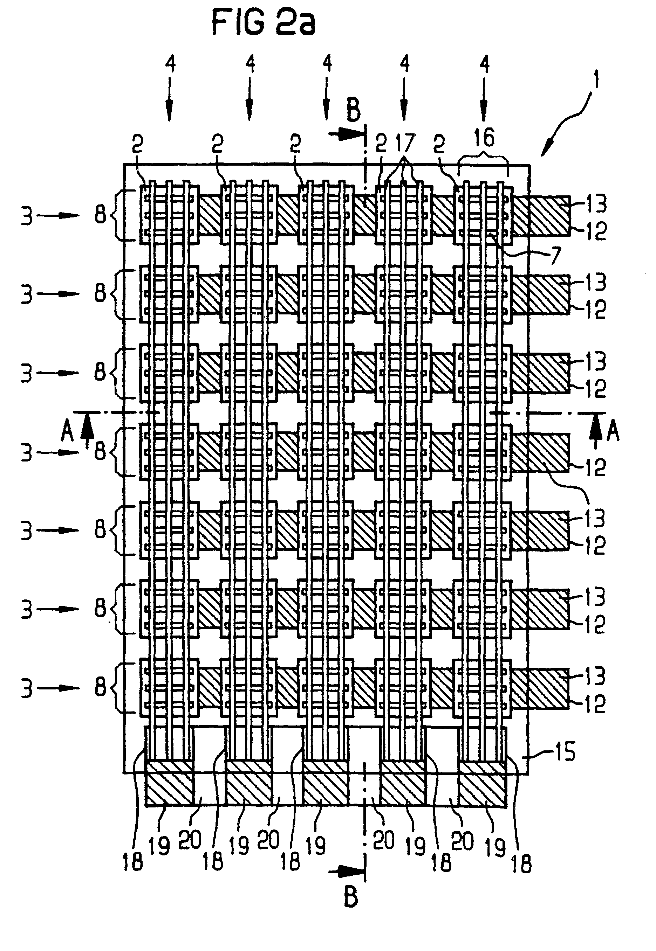

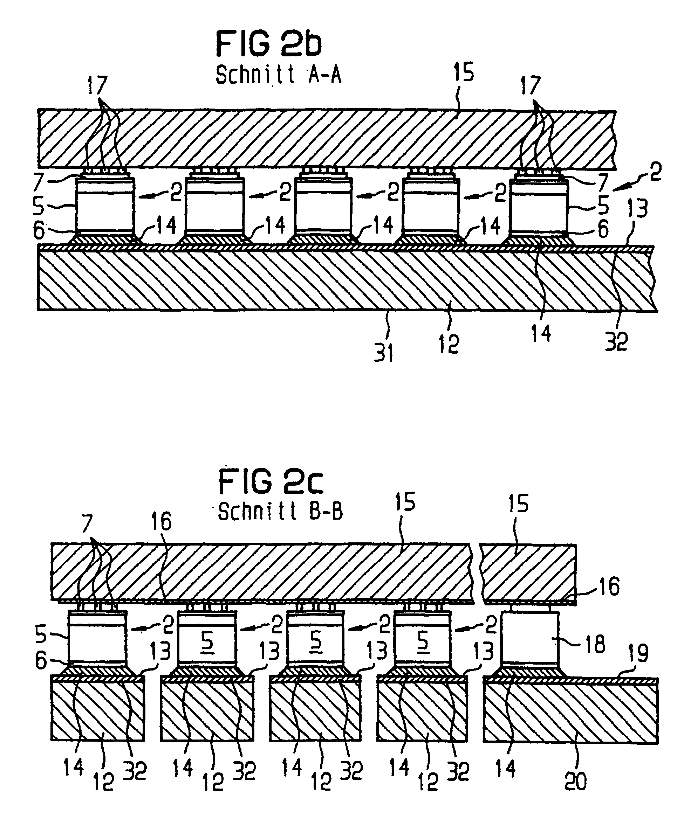

Bei der nicht zur Erfindung gehörenden LED-Vorrichtung 1 von Figur 1 weist der LED-Chip 2 als lichtemittierenden Körper einen Halbleiterkörper 5, eine auf einer Lichtaustrittsfläche des Halbleiterkörpers 5 aufgebrachte Vorderseitenkontaktmetallisierung 8 und eine auf einer der Lichtaustrittsfläche gegenüberliegenden Seite des Halbleiterkörpers 5 aufgebrachte Rückseitenkontaktmetallisierung 6 auf. Der Halbleiterkörper 5 besteht beispielsweise aus einer herkömmlichen lichtemittierenden Schichtenfolge aus III/V-Halbleitermaterialien oder aus anderen zur Herstellung von LED-Chips geeigneten Materialkombinationen (man vgl. dazu und zu den Materialien für die Vorderseiten- 8 und die Rückseitenkontaktmetallisierung 6 die Figuren 2a und 2b mit zugehörigem Beschreibungsteil).

Unter Lichtaustrittsfläche eines LED-Chips 2 ist im Allgemeinen diejenige Seitenfläche des Halbleiterkörpers 5 zu verstehen, durch die der größte Teil des Lichtes aus dem Halbleiterkörper 5 austritt.

Über der Vorderseite des LED-Chips 2 ist ein lichtdurchlässiger erster Leiterbahnträger 15 mit einem ersten elektrischen Leiter 16 angeordnet. Der erste Leiterbahnträger 15 ist z. B. eine aus Glas, Kunststoff, Halbleitermaterial (z. B. SiC für λ > 400nm, GaP für λ > 550nm, GaAs für λ > 900nm usw.) oder einem anderen geeigneten lichtdurchlässigen Material gefertigte Platte und als erster elektrischer Leiter ist beispielsweise eine mittels Aufdampfen oder Sputtern aufgebrachte Schicht aus Au, A1, einer A1-Basislegierung oder einem anderen geeigneten elektrisch leitenden Werkstoff verwendet.

Der erste elektrische Leiter 16 ist mit der Vorderseitenkontaktmetallisierung 8 beispielsweise mittels eines metallischen Lotes (z. B. PbSn-Lot) oder mittels eines elektrisch leitenden Klebstoffes verbunden. Zum Löten kann z. B. ein Laserlötverfahren eingesetzt werden, bei dem der Laserstrahl durch den ersten Leiterbahnträger 15 hindurch zur Lötstelle geführt ist.

An der Rückseite des LED-Chips 2 befindet sich ein zweiter Leiterbahnträger 31, der beispielsweise aus Glas, Glaskeramik, Kunststoff, Halbleitermaterial oder Metall besteht. Im Falle der Verwendung eines isolierenden Materials für den zweiten Leiterbahnträger 31 ist auf diesem ein zweiter elektrischer Leiter 13, beispielsweise in Form einer Schicht aus Au, A1 und/oder einem anderen geeigneten elektrisch leitenden Material ausgebildet. Im Falle eines zweiten Leiterbahnträgers 31 aus Halbleitermaterial kann der zweite elektrische Leiter 13 als hochdotiertes Gebiet ausgebildet sein. Der zweite elektrische Leiter 13 bzw. der Leiterbahnträger 31 ist z. B. mittels eines Verbindungsmittels 14 aus metallischem Lot, Klebstoff usw. mit der Rückseitenkontaktmetallisierung 6 elektrisch leitend verbunden.

Um mögliche Toleranzen in der Größe verschiedener LED-Chips und/oder Unebenheiten der Leiterbahnträger 15, 31 auszugleichen, kann das Verbindungsmittel 14, der zweite elektrische Leiter 13, der erste Leiterbahnträger 15 und/oder der zweite Leiterbahnträger 31 plastisch oder elastisch verformbar ausgebildet sein. Die Leiterbahnträger 15,31 können hierzu beispielsweise aus elastischen Kunststofffolienmaterial gefertigt sein.

Bei dem in den Figuren 2a bis 2c dargestellten ersten Ausführungsbeispiel der erfindungsgemäßen LED-Vorrichtung 1 sind die LED-Chips 2 in Zeilen 3 und Spalten 4 angeordnet. Die LED-Chips 2 weisen jeweils einen Halbleiterkörper 5, eine Rückseitenkontaktmetallisierung 6 und eine aus drei Metallisierungsstreifen 7 bestehende Vorderseitenkontaktmetallisierung 8 auf.

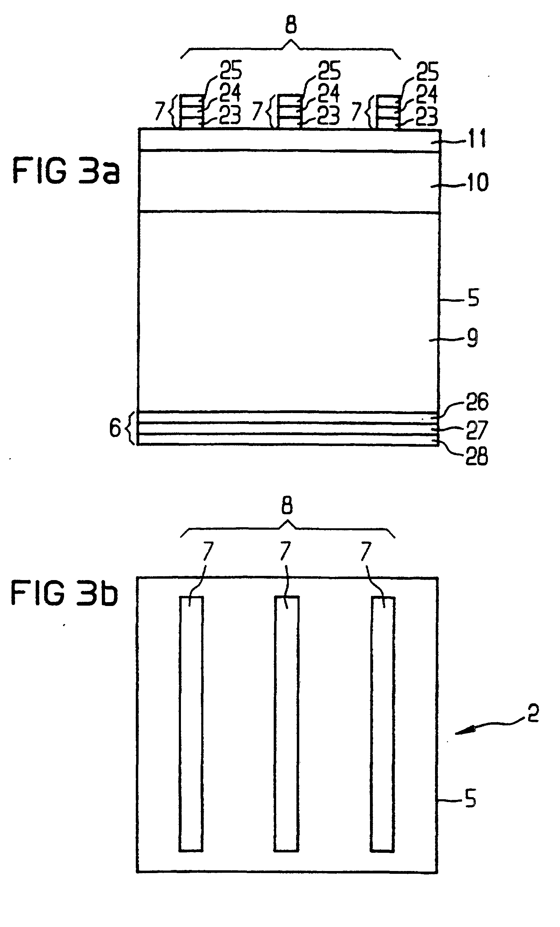

Der Halbleiterkörper 5 - man vgl. dazu die Figuren 3a und 3b - setzt sich beispielsweise aus einem n-leitenden GaP-Substrat 9, einer über dem Substrat 9 angeordneten n-leitenden GaAsP-Schicht 10 und einer über der GaAsP-Schicht 10 angeordneten p-leitenden GaAsP-Schicht 11 zusammen. Er kann jedoch auch jede andere zur Herstellung von Leuchtdioden geeignete Materialkombination bzw. Schichtenfolge aufweisen. Bekannt sind z. B. Leuchtdioden aus GaₓAlₓ₋₁As (0 ≤ x ≤ 1), (GaAlIn)P, GaₓInₓ₋₁As_{y}P_{1-y} (0 ≤ x ≤ 1; 0 ≤ y ≤ 1) , GaₓAlₓ₋₁N (0 ≤ x ≤ 1), GaₓInₓ₋₁N (0 ≤ x ≤ 1), ZnSe und/oder SiC.

Die Kontaktmetallisierungsstreifen 7 sind beispielsweise mittels Aufdampfen oder Sputtern hergestellt. Im zweiten Ausführungsbeispiel handelt es sich hierbei um p-Metallisierungen, die sich z. B. jeweils aus einer auf der p-leitenden GaASP-Schicht 11 aufgebrachten Ti-Schicht 23, einer über der Ti-Schicht 23 angeordneten Pt-Schicht 24 und einer über der Pt-Schicht 23 angeordneten AuSn-Schicht 25 zusammensetzen. Die Art des Metalls und die Schichtenfolge für die Vorderseitenkontaktmetallisierungen 8 ist natürlich von der jeweiligen Materialkombination der verwendeten Halbleiterkörper 5 abhängig. Der Fachmann kann selbstverständlicherweise jede ihm für das jeweilige Halbleitermaterial als geeignet bekannte Metallisierung verwenden.

Die Rückseitenkontaktmetallisierungen 6 weisen beispielsweise ebenfalls einen Dreischichtaufbau auf, bestehend aus einer AuGe-Schicht 26 (99:1), einer Ni-Schicht 27 und einer Au-Schicht 28. Auch hier ist die Art des eingesetzten Metalls von der Materialkombination des Halbleiterkörpers 5 abhängig.

Unterhalb den LED-Chips 2 befindet sich eine Mehrzahl von Trägerbalken 12, auf deren Vorderseite jeweils ein zweiter elektrischer Leiter 13, z. B. in Form einer Metallisierungsschicht 32, aufgebracht ist. Jeder LED-Chip 2 ist mittels eines elektrisch leitenden Verbindungsmittels 14, z. B. ein metallisches Lot oder ein elektrisch leitender Klebstoff, mit dem zugeordneten zweiten elektrischen Leiter 13 verbunden. Die Trägerbalken 12 sind so angeordnet, daß der zweite elektrische Leiter 13 jeweils eines Trägerbalkens 12 die Rückseitenkontaktmetallisierungen 6 der jeweils zu einer Zeile 3 gehörenden LED-Chips 2 untereinander elektrisch leitend verbindet.

Die Trägerbalken 12 können beispielsweise aus Kunststoff, Glaskeramik, Glas, Halbleitermaterial, Epoxydharz, Pertinax oder aus einem anderen geeigneten Material hergestellt sein. Die zweiten elektrischen Leiter 13 bestehen beispielsweise aus Cu, A1, einer A1-Basislegierung oder aus einem anderen geeigneten metallischen Werksoff und sind beispielsweise mittels Aufdampfen oder Sputtern auf die Trägerbalken 12 aufgebracht. Ebenso ist es denkbar, für die Trägerbalken 12 an sich ein elektrisch leitendes Material, wie beispielsweise Cu, oder ein Halbleitermaterial, wie z. B. Si, zu verwenden. Im Falle von elektrisch leitenden Trägerbalken 12 sind keine Metallisierungsschichten 32 erforderlich und im Falle von Trägerbalken 12 aus Halbleitermaterial können anstelle der Metallisierungsschichten 32 die Vorderseiten der Trägerbalken 12 hochdotiert sein und damit eine ausreichende elektrische Leitfähigkeit aufweisen.

Oberhalb der LED-Chips 2 befindet sich ein lichtdurchlässiger Leiterbahnträger 15, der beispielsweise aus Glas, Kunststoff, Halbleitermaterial oder aus einem anderen geeigneten Werkstoff besteht. Der Leiterbahnträger 15 weist eine Mehrzahl von parallel zueinander verlaufenden Leiterbahnen auf, von denen wiederum jede aus drei parallel zueinander verlaufenden Leiterbahnmetallisierungsstreifen 17 besteht und einen ersten elektrischen Leiter 16 bildet. Die Leiterbahnen sind derart angeordnet, daß jeweils die Vorderseitenkontaktmetallisierungen 8 der zu einer Spalte gehörenden LED-Chips 2 untereinander elektrisch leitend verbunden sind.

Die Leiterbahnmetallisierungsstreifen 17 bestehen beispielsweise wiederum aus Au, A1, einer A1-Basislegierung oder aus einem anderen geeigneten metallischen Werkstoff und sind beispielsweise mittels Aufdampfen oder Sputtern auf dem Leiterbahnträger 15 aufgebracht. Die Zahl der Leiterbahnmetallisierungsstreifen 17 ist beliebig und nicht auf drei beschränkt. Im Falle eines Leiterbahnträgers 15 aus Halbleitermaterial wie zum Beispiel Si, können die ersten elektrischen Leiter 16 als hochdotierte Streifen im Leiterbahnträger 15 ausgebildet sein.

Am unteren Ende von jeder Spalte 4 befindet sich zwischen dem Leiterbahnträger 15 und einer Anodenanschlußplatte 20 jeweils ein sogenannter Jumper-Chip 18, beispielsweise ein Silizium-Chip, der die ersten elektrischen Leiter 16 elektrisch leitend mit einer auf der Anodenanschlußplatte 20 befindlichen Anodenanschlußmetallisierung 19 verbindet. Damit sind sämtliche Anschlüsse für das aus Zeilen 3 und Spalten 4 bestehende LED-Feld in einer Ebene angeordnet, was sich vorteilhaft für die weiteren Herstellungsprozesse, wie beispielsweise Anschließen an eine elektrische Ansteuerschaltung, auswirkt.

Der Vollständigkeit halber sei an dieser Stelle erwähnt, daß die Zahl der Kontaktmetallisierungsstreifen 7 je Vorderseitenkontaktmetallisierung 8 und die Zahl der Leiterbahnmetallisierungsstreifen 17 je ersten elektrischen Leiter 16 beliebig sein kann und nicht auf drei beschränkt ist.

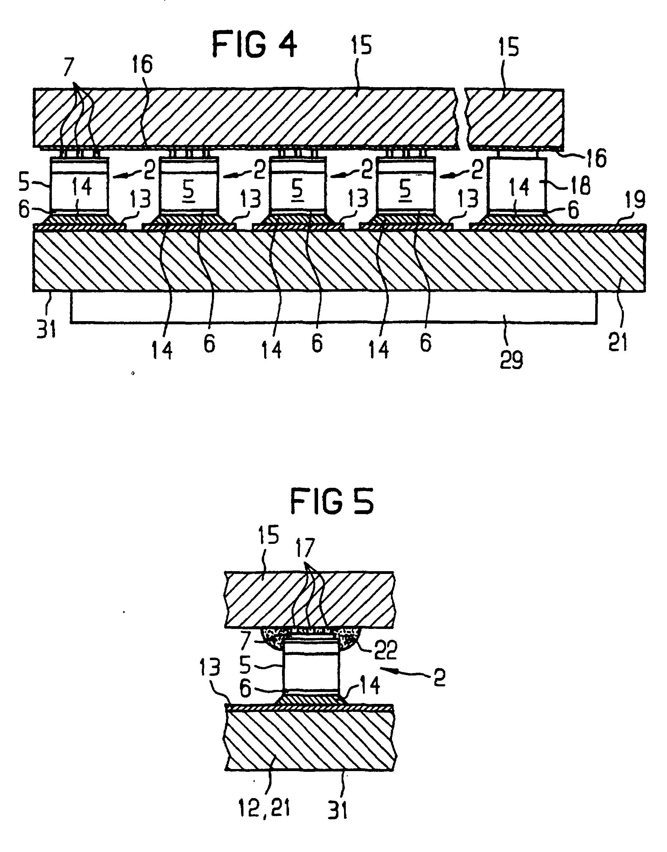

Das in Figur 4 dargestellte zweite Ausführungsbeispiel der erfindungsgemäßen LED-Vorrichtung unterscheidet sich vom ersten Ausführungsbeispiel im wesentlichen nur dadurch, daß anstelle der Trägerbalken 12 eine einzige elektrisch isolierende Platte 21 verwendet ist. Auf dieser elektrisch isolierenden Platte 21, die beispielsweise aus Glas, Glaskeramik, Halbleitermaterial, aus Kunststoff (z. B. HT-Thermoplast) oder aus einem anderen geeigneten Werkstoff besteht, sind zweite elektrische Leiter 13 - beispielsweise mittels Aufdampfen oder Sputtern hergestellte Metallisierungsschichten - aufgebracht, die entsprechend dem zweiten Ausführungsbeispiel die Rückseitenkontaktmetallisierungen 6 der jeweils zu einer Zeile gehörenden LED-Chips 2 untereinander elektrisch leitend verbinden. Ebenso sind auf dieser Platte 21 Anodenanschlußmetallisierungen 19 aufgebracht, die über Jumper-Chips 18 mit den ersten elektrischen Leitern 16 elektrisch leitend verbunden sind. Die restlichen Bestandteile der LED-Vorrichtungen gemäß dem dritten Ausführungsbeispiel nach Figur 3 entsprechen denen des zweiten Ausführungsbeispieles nach Figur 2a und sind mit denselben Bezugszeichen versehen.

Im Falle einer Platte 21 aus Halbleitermaterial, wie z. B. Si, können anstelle von Metallisierungsschichten und/oder der Anodenanschlußmetallisierungen 19 in der Platte 21 hochdotierte Gebiete ausgebildet sein, die die zweiten elektrischen Leiter 13 bzw. die Anodenanschlüsse bilden.

Beim zweiten Ausführungsbeispiel ist von wesentlicher Bedeutung, daß für die Platte 21 und für den ersten Leiterbahnträger 15 möglichst Materialien verwendet sind, die einen ähnlichen thermischen Ausdehnungskoeffizienten besitzen. Eine stark unterschiedliche thermische Ausdehnung von Platte 21 und Leiterbahnträger 15 würde nämlich bei Temperaturschwankungen zu erheblichen mechanischen Spannungen in der LED-Vorrichtung 1 führen, die bekannterweise die Funktionseigenschaften und die Alterungsbeständigkeit von LED-Vorrichtungen beeinträchtigen können.

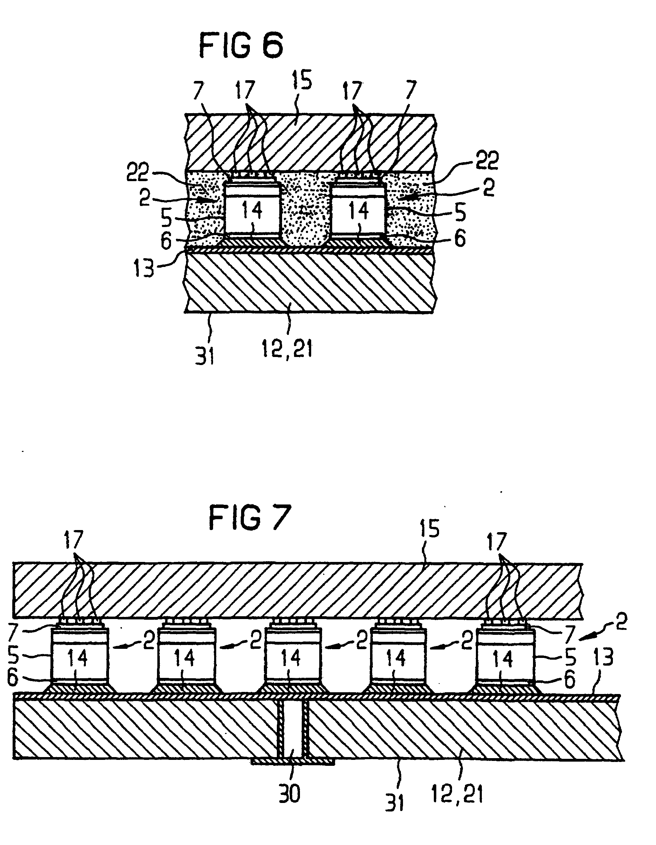

Um die Lichtauskopplung aus der LED-Vorrichtung 1 zu erhöhen, kann, wie in den Figuren 5 und 6 gezeigt, zwischen der Lichtaustrittsfläche eines jeden LED-Chips 2 und dem Leiterbahnträger 15 ein Koppelmedium 22 angeordnet sein bzw. der Zwischenraum zwischen Trägerbalken 12/Platte 21 und Leiterbahnträger 15 mit einem Koppelmedium 22 ausgefüllt sein. Das Koppelmedium 22 kann beispielsweise aus Epoxidharz, Silikon oder aus einem anderen dem Fachmann als für diesen Zweck geeignet bekannten Material bestehen.

Denkbar ist auch, daß die LED-Chips 2 nicht in Zeilen 3 und Spalten 4, sondern diagonal, ringförmig oder in anderer Art und Weise angeordnet und in erste und zweite Gruppen unterteilt, miteinander verschaltet sind.

Bei Verwendung einer Platte 21 als zweiten Leiterbahnträger 31 für die zweiten elektrischen Leiter 13 kann die elektronische Ansteuerschaltung 29 (Fig. 4) für die LED-Vorrichtung 1 auf der Rückseite der Platte 21 angeordnet sein.

Weiterhin ist denkbar, daß die Rückseitenkontaktmetallisierungen 6 und/oder die zweiten elektrischen Leiter 13 mittels elektrisch leitender Durchführungen (Vias) 30 (man vgl. Fig. 7) durch die Platte 21 hindurch mit der elektronischen Ansteuerschaltung 29 verbunden sind. Mit dieser Weiterbildung der Erfindung ist die Herstellung eines Kontinuums aus LED-Chips 2 möglich.

Weiterhin ist es möglich die Platte 21 als sogenannte Multilayer-Platine auszubilden, wodurch die notwendige Fläche für die Leiterbahnanordnung der Platte 21 verringert werden kann.

Um beim ersten oder zweiten Ausführungsbeispiel mögliche Toleranzen in den Abmessungen der LED-Chips und/oder Unebenheiten des ersten und/oder des zweiten Leiterbahnträgers 15 bzw. 31 auszugleichen, können vorteilhafterweise der erste Leiterbahnträger 15, der zweite Leiterbahnträger 31, die ersten elektrischen Leiter 16, die zweiten elektrischen Leiter 13 und/oder das Verbindungsmittel 14 plastisch oder elastisch verformbar ausgebildet sein, so daß die Toleranzen ausgeglichen werden können und eine sichere Verbindung zwischen den ersten elektrischen Leitern 16 und den Vorderseitenkontaktmetallisierungen 8 und zwischen den zweiten elektrischen Leitern 13 und den Rückseitenkontaktmetallisierungen 6 gewährleistet ist. Demgemäß kann der erste Leiterbahnträger 15 und/oder der zweite Leiterbahnträger 31 z. B. als strukturiert leitfähige, im Wesentlichen aus Kunststoff bestehende Folie ausgebildet sein.

Selbstverständlicherweise ist die erfindungsgemäße LED-Vorrichtung nicht ausschließlich auf die Verwendung von Halbleiter-LED-Chips beschränkt, sondern kann ebenso beispielsweise bei Verwendung von Polymer-LED-Chips genutzt werden.

### Bezugszeichenliste:

- 1: LED-Vorrichtung
- 2: LED-Chip
- 3: Pfeile
- 4: Spalte
- 5: Halbleiterkörper
- 6: Rückseitenkontaktmetallisierung
- 7: Kontaktmetallisierungsstreifen
- 8: Vorderseitenkontaktmetallisierung
- 9: n-leitendes GaP-Substrat
- 10: n-leitende GaAsP-Schicht
- 11: p-leitende GaAsP-Schicht
- 12: Trägerbalken
- 13: zweiter elektrischer Leiter
- 14: Verbindungsmittel
- 15: erster Leiterbahnträger
- 16: erster elektrischer Leiter
- 17: Leiterbahnmetallisierungsstreifen
- 18: Jumper-Chip
- 19: Anodenanschlußmetallisierung
- 20: Anodenanschlußplatte
- 21: Platte
- 22: Koppelmedium
- 23: Ti-Schicht
- 24: Pt-Schicht
- 25: AuSn-Schicht
- 26: AuGe-Schicht
- 27: Ni-Schicht
- 28: Au-Schicht
- 29: Ansteuerschaltung
- 30: Durchführung (Via)
- 31: zweiter Leiterbahnträger
- 32: Metallisierungsschicht

## Patentansprüche

1. LED-Vorrichtung (1) mit mindestens einem LED-Chip (2), bei dem auf einer Lichtaustrittsfläche eines lichtemittierenden Körpers (5) eine Vorderseitenkontaktmetallisierung (8) und auf einer der Lichtaustrittsfläche gegenüberliegenden Seite des lichtemittierenden Körpers eine Rückseitenkontaktmetallisierung (6) angeordnet ist und der zwischen einem ersten (15) und einem zweiten Leiterbahnträger angeordnet ist, wobei der erste Leiterbahnträger (15) lichtdurchlässig ist und mindestens einen ersten elektrischen Leiter (16) aufweist, der die Vorderseitenkontaktmetallisierung (8) kontaktiert, und der zweite Leiterbahnträger (31) mindestens einen zweiten elektrischen Leiter (13) aufweist, der die Rückseitenkontaktmetallisierung (6) kontaktiert,
**dadurch gekennzeichnet, daß**
der erste, die Vorderseitenkontaktmetallisierung (8) des LED-Chips (2) kontaktierende elektrische Leiter (16) eine Mehrzahl von in einem Abstand zueinander auf dem ersten Leiterbahnträger (15) aufgebrachten oder ausgebildeten Leiterbahnen (17) aufweist.

2. LED-Vorrichtung (1) nach Anspruch 1,
**dadurch gekennzeichnet,**
**dass** die Vorderseitenkontaktmetallisierung (8) mehrere in einem Abstand voneinander angeordnete Kontaktmetallisierungsstreifen (7) aufweist.

3. LED-Vorrichtung (1) nach Anspruch 2,
**dadurch gekennzeichnet,**
**dass** die Kontaktmetallisierungsstreifen (7) der Vorderseitenkontaktmetallisierung (8) jeweils die Leiterbahnen (17) des dieser Vorderseitenkontaktmetallisierung (8) zugeordneten ersten elektrischen Leiters (16) kreuzen.

4. LED-Vorrichtung nach einem der Anspruche 1 bis 3,
**dadurch gekennzeichnet,**
**dass** ein freier Zwischenraum zwischen der Lichtaustrittsfläche des LED-Chips (2) und dem ersten Leiterbahnträger (15) mit einem optischen Koppelmedium (22) gefüllt ist.

5. LED-Vorrichtung (1) nach einem der Ansprüche 1 bis 4,
**dadurch gekennzeichnet,**
a)dass zwischen dem ersten (15) und dem zweiten Leiterbahnträger (31) eine Mehrzahl von LED-Chips (2) angeordnet sind,
b)dass auf dem ersten Leiterbahnträger (15) eine Mehrzahl von ersten elektrischen Leitern (16) vorgesehen ist, von denen jeder die Vorderseitenkontaktmetallisierung (8) von mindestens einem LED-Chip (2) kontaktiert, und
c)dass auf dem zweiten Leiterbahnträger (31) eine Mehrzahl von zweiten elektrischen Leitern (13) vorgesehen ist, von denen jeder die Rückseitenkontaktmetallisierung (6) von mindestens einem LED-Chip (2) kontaktiert.

6. LED-Vorrichtung nach Anspruch 5,
**dadurch gekennzeichnet,**
**dass** die LED-Chips (2) in Zeilen (3) und Spalten (4) angeordnet sind, dass die Vorderseitenkontaktmetallisierungen (8) der LED-Chips (2) jeder Spalte (4) jeweils mittels eines ersten elektrischen Leiters (16) und die Rückseitenkontaktmetallisierungen (6) der LED-Chips (2) jeder Zeile (3) jeweils mittels eines zweiten elektrischen Leiters (13) miteinander elektrisch leitend verbunden sind.

7. LED-Vorrichtung (1) nach Anspruch 5 oder 6,
**dadurch gekennzeichnet,**
**dass** der zweite Leiterbahnträger (31) eine Mehrzahl von einen Abstand voneinander aufweisenden, nebeneinander angeordneten Trägerbalken (12) aufweist, auf denen als zweite elektrische Leiter (13) Metallisierungsschichten (32) aufgebracht sind oder die zumindest teilweise aus elektrisch leitendem Material bestehen.

8. LED-Vorrichtung (1) nach Anspruch 7,
**dadurch gekennzeichnet,**
**dass** jeder zweite elektrische Leiter (13) auf einem separaten Trägerbalken (12) aufgebracht bzw. als separater Trägerbalken (12) ausgebildet ist.

9. LED-Vorrichtung (1) nach Anspruch 5 oder 6,
**dadurch gekennzeichnet,**
**dass** der zweite Leiterbahnträger (31) eine elektrisch isolierende Platte (21) aufweist, auf der alle zweiten elektrischen Leiter (13) angeordnet sind.

10. LED-Vorrichtung (1) nach einem der Ansprüche 1 bis 9,
**dadurch gekennzeichnet,**
**dass** der erste (15) und der zweite Leiterbahnträger (31) aus Materialien bestehen, die einen ähnlichen thermischen Ausdehnungskoeffizienten aufweisen.

11. LED-Vorrichtung (1) nach einem der Ansprüche 1 bis 10,
**dadurch gekennzeichnet,**
**dass** der erste Leiterbahnträger (15) aus einem elastischen Material gefertigt ist.

12. LED-Vorrichtung (1) nach einem der Ansprüche 1 bis 11,
**dadurch gekennzeichnet,**
**dass** der zweite Leiterbahnträger (31)aus einem elastischen Material gefertigt ist.

13. LED-Vorrichtung (1) nach einem der Ansprüche 1 bis 12,
**dadurch gekennzeichnet,**
**dass** mindestens einer der zweiten Leiter (13) elastisch und/oder plastisch verformbaren ausgebildet ist.

14. LED-Vorrichtung nach einem der Ansprüche 1 bis 13,
**dadurch gekennzeichnet,**
**dass** mindestens ein zweiter elektrischer Leiter (13) mittels eines elastisch oder plastisch verformbaren elektrisch leitenden Verbindungsmittels (14) mit den zugehörigen Rückseitenkontaktmetallisierungen (6) verbunden ist.

## Claims

1. LED device (1) having at least one LED chip (2), in which chip a front contact metallization (8) is arranged on a light exit surface of a light-emitting member (5), and a rear contact metallization (6) is arranged on a side of the light-emitting member opposite the light exit surface and which LED chip is arranged between a first (15) and a second conductor track support, the first conductor track support (15) being transparent and having at least one first electric conductor (16) which makes contact with the front contact metallization (8), and the second conductor track support (31) having at least one second electric conductor (13) which makes contact with the rear contact metallization (6), **characterized in that** the first electric conductor (16), which makes contact with the front contact metallization (8) of the LED chip (2), has a plurality of conductor tracks (17) applied to or constructed on the first conductor track support (15) at a mutual spacing.

2. LED device (1) according to Claim 1, **characterized in that** the front contact metallization (8) has several contact metallization strips (7) arranged at a spacing from one another.

3. LED device (1) according to Claim 2, **characterized in that** the contact metallization strips (7) of the front contact metallization (8) in each case cross the conductor tracks (17) of the first electric conductor (16) assigned to this front contact metallization (8).

4. LED device according to one of Claims 1 to 3, **characterized in that** a free interspace between the light exit surface of the LED chip (2) and the first conductor track support (15) is filled with an optical coupling medium (22).

5. LED device (1) according to one of Claims 1 to 4, characterized
a) in that a plurality of LED chips (2) are arranged between the first (15) and the second conductor track support (31),
b) in that there is provided on the first conductor track support (15) a plurality of first electric conductors (16) of which each makes contact with the front contact metallization (8) of at least one LED chip (2), and
c) in that there is provided on the second conductor track support (31) a plurality of second electric conductors (13) of which each makes contact with the rear contact metallization (6) of at least one LED chip (2).

6. LED device according to Claim 5, **characterized in that** the LED chips (2) are arranged in rows (3) and columns (4), and **in that** the front contact metallizations (8) of the LED chips (2) of each column (4) are interconnected in an electrically conducting fashion in each case by means of a first electric conductor (16), and the rear contact metallizations (6) of the LED chips (2) of each row (3) are interconnected in an electrically conducting fashion in each case by means of a second electric conductor (13).

7. LED device (1) according to Claim 5 or 6, **characterized in that** the second conductor track support (31) has a plurality of support beams (12) which are mutually spaced and arranged next to one another and to which metallization coatings (32) are applied as second electric conductors (13), or which comprise electrically conducting material at least partially.

8. LED device (1) according to Claim 7, **characterized in that** each second electric conductor (13) is applied to a separate support beam (12) or is constructed as a separate support beam (12).

9. LED device (1) according to Claim 5 or 6, **characterized in that** the second conductor track support (31) has an electrically insulating plate (21) on which all the second electric conductors (13) are arranged.

10. LED device (1) according to one of Claims 1 to 9, **characterized in that** the first (15) and the second conductor track support (31) consist of materials which have a similar coefficient of thermal expansion.

11. LED device (1) according to one of Claims 1 to 10, **characterized in that** the first conductor track support (15) is produced from an elastic material.

12. LED device (1) according to one of Claims 1 to 11, **characterized in that** the second conductor track support (31) is produced from an elastic material.

13. LED device (1) according to one of Claims 1 to 12, **characterized in that** at least one of the two conductors (13) is constructed to be capable of elastic and/or plastic deformation.

14. LED device according to one of Claims 1 to 13, **characterized in that** at least one second electric conductor (13) is connected to the associated rear contact metallizations (6) with the aid of an electrically conducting connecting means (14) which is capable of elastic or plastic deformation.

## Revendications

1. Dispositif à LED (1) comportant au moins une puce LED (2), sur laquelle une métallisation de contact de face avant (8) est disposée sur une surface de sortie de la lumière d'un corps photoémetteur (5) et une métallisation de contact de face arrière (6) sur le côté du corps photoémetteur opposé à la surface de sortie de la lumière et qui est disposée entre un premier (15) et un deuxième support de pistes conductrices, le premier support de pistes conductrices (15) étant transparent et présentant au moins un premier conducteur électrique (16) qui est en contact avec la métallisation de contact de face avant (8), et le deuxième support de pistes conductrices (31) présentant au moins un deuxième conducteur électrique (13) qui est en contact avec la métallisation de contact de face arrière (6), **caractérisé en ce que** le premier conducteur électrique (16) qui est en contact avec la métallisation de contact de face avant (8) de la puce LED (2) présente une pluralité de pistes conductrices (17) espacées les unes des autres et appliquées ou façonnées sur le premier support de pistes conductrices (17).

2. Dispositif à LED (1) selon la revendication 1, **caractérisé en ce que** la métallisation de contact de face avant (8) présente plusieurs bandes de métallisation de contact (7) espacées les unes des autres.

3. Dispositif à LED (1) selon la revendication 2, **caractérisé en ce que** les bandes de métallisation de contact (7) de la métallisation de contact de face avant (8) croisent chacune les pistes conductrices (17) du premier conducteur électrique (16) associé à cette métallisation de contact de face avant (8).

4. Dispositif à LED selon l'une des revendications 1 à 3, **caractérisé en ce qu'**un espace intermédiaire libre entre la surface de sortie de la lumière de la puce LED (2) et le premier support de pistes conductrices (15) est rempli d'un support de couplage optique (22).

5. Dispositif à LED (1) selon l'une des revendications 1 à 4, caractérisé en ce
a) qu'une pluralité de puces LED (2) est disposée entre le premier (15) et le deuxième support de pistes conductrices (31),
b) qu'une pluralité de premiers conducteurs électriques (16) est prévue sur le premier support de pistes conductrices (15), lesquels sont chacun en contact avec la métallisation de contact de face avant (8) d'au moins une puce LED (2), et
c) qu'une pluralité de deuxièmes conducteurs électriques (13) est prévue sur le deuxième support de pistes conductrices (31), lesquels sont chacun en contact avec la métallisation de contact de face arrière (6) d'au moins une puce LED (2).

6. Dispositif à LED selon la revendication 5, **caractérisé en ce que** les puces LED (2) sont disposées en lignes (3) et en colonnes (4), que les métallisations de contact de face avant (8) des puces LED (2) de chaque colonne (4) sont chacune reliées électriquement entre elles à l'aide d'un premier conducteur électrique (16) et les métallisations de contact de face arrière (6) des puces LED (2) de chaque ligne (3) sont chacune reliées électriquement entre elles à l'aide d'un deuxième conducteur électrique (13).

7. Dispositif à LED (1) selon la revendication 5 ou 6, **caractérisé en ce que** le deuxième support de pistes conductrices (31) présente une pluralité de barres supports (12) disposées les unes à côté des autres et présentant un écart entre elles, sur lesquelles sont appliquées des couches de métallisation (32) faisant office de deuxième conducteur électrique (13) ou qui se composent au moins en partie d'un matériau conducteur d'électricité.

8. Dispositif à LED (1) selon la revendication 7, **caractérisé en ce que** chaque deuxième conducteur électrique (13) est disposé sur une barre support (12) séparée ou est réalisé sous la forme d'une barre support (12) séparée.

9. Dispositif à LED (1) selon la revendication 5 ou 6, **caractérisé en ce que** le deuxième support de pistes conductrices (31) présente une plaque isolante électrique (21) sur laquelle sont disposés tous les deuxièmes conducteurs électriques (13).

10. Dispositif à LED (1) selon l'une des revendications 1 à 9, **caractérisé en ce que** le premier (15) et le deuxième support de pistes conductrices (31) se composent de matériaux qui présentent un coefficient de dilatation thermique similaire.

11. Dispositif à LED (1) selon l'une des revendications 1 à 10, **caractérisé en ce que** le premier support de pistes conductrices (15) est fabriqué dans un matériau élastique.

12. Dispositif à LED (1) selon l'une des revendications 1 à 11, **caractérisé en ce que** le deuxième support de pistes conductrices (31) est fabriqué dans un matériau élastique.

13. Dispositif à LED (1) selon l'une des revendications 1 à 12, **caractérisé en ce qu'**au moins l'un des deuxièmes conducteurs (13) est déformable par effet élastique et/ou plastique.

14. Dispositif à LED (1) selon l'une des revendications 1 à 13, **caractérisé en ce qu'**au moins un deuxième conducteur électrique (13) est relié aux métallisations de contact de face arrière (6) correspondantes au moyen d'un élément de liaison conducteur électrique déformable par effet élastique ou plastique.
